# EUROPÄISCHE PATENTSCHRIFT

(11) **EP 1 795 870 B1**
(45) Veröffentlichungstag und Bekanntmachung des Hinweises auf die Patenterteilung: **01.07.2015**
(21) Anmeldenummer: 06024569.3
(22) Anmeldetag: 28.11.2006
(51) Int. Cl.: G01D 5/245, G05B 19/19, G06F 11/07, H03M 1/10, H03M 1/14, G01D 5/244

(54) **Schaltungsanordnung und Verfahren zur Feststellung von Zählfehlern in einer Positionsmesseinrichtung**
Circuitry for and method of identifying counting errors in a position detection device
Circuits et méthode d'identifier des erreurs de compte dans un dispositif de détection de position

(30) Priorität: 08.12.2005 JP 2005354205
(43) Veröffentlichungstag der Anmeldung: 13.06.2007
(73) Patentinhaber: Dr. Johannes Heidenhain GmbH, 83301 Traunreut (DE)
(72) Erfinder: Yamamoto, Takeshi, Hachioji-shi, Tokyo-to 193-0826 (JP)
(74) Vertreter: Pleyer, Hans Anno

(56) Entgegenhaltungen:
- EP-A1- 0 431 181
- EP-A1- 0 735 654
- DE-A1- 19 801 129
- JP-A- 5 288 572

## Beschreibung

Die vorliegende Erfindung betrifft eine Positionsmesseinrichtung, die an einem zu messenden Objekt, bei dem es sich beispielsweise um den Rotor eines Motors oder um einen beweglichen Körper, wie etwa den Werkzeugschlitten einer Werkzeugmaschine handelt, angebracht ist und das Positionsverschiebungsausmaß des zu messenden Objekts, das heißt, die Umdrehungszahl und/oder den Umdrehungswinkel oder die Bewegungsstrecke feststellt. Insbesondere handelt es sich um eine Schaltungsanordnung sowie ein Verfahren zur Feststellung von Zählfehlern in einer derartigen Positionsmesseinrichtung gemäß den Ansprüchen 1 und 7.

Eine ähnliche Fehlererkennungsschaltung wird in EP0735654 offenbart. Im Allgemeinen sind Positionsmesseinrichtungen in Drehgeber und lineare Positionsmessgeräte unterteilt. Bei den Drehgebern werden ferner inkrementale und absolute Drehgeber unterschieden. Besonders bei absoluten Drehgebern gibt es Multiturn-Drehgeber, die in einer Multiturnstufe auch eine Feststellung der Umdrehungszahl vornehmen. Bei Multiturn-Drehgebern sind Positionsmesseinrichtungen bekannt, die, wie zum Beispiel in der JP63083612A2 offenbart, neben einem Aufbau zur Feststellung des Positionsverschiebungsausmaßes bzw. Positionsverschiebungswinkels innerhalb einer Umdrehung auch einen Aufbau zur Feststellung der Anzahl der zurückgelegten Umdrehungen aufweisen.

Der Multiturn-Drehgeber dieses Literaturbeispiels ist mit einem optischen absoluten Geber zur Feststellung des absoluten Winkels innerhalb einer Umdrehung und einem magnetischen Geber, der die Anzahl der zurückgelegten Umdrehungen feststellt, versehen. Der optische absolute Geber zur Feststellung des absoluten Winkels innerhalb einer Umdrehung besteht u.a. aus einer an einer Welle angebrachten Codescheibe, einer Leuchtdiode, um die Codescheibe zu bestrahlen, einer Photodiodenanordnung eines Lichtempfangselements, das das Licht der Leuchtdiode über eine Abtastplatte empfängt, und eine Wellenformkorrekturschaltung zur Korrektur der Wellenform des Feststellsignals von der Photodiodenanordnung zu Rechteckwellen. Der magnetische Geber zur Feststellung von mehreren Umdrehungen besteht u.a. aus einer Codescheibe am Drehteil, die mit einem als Ringmagnet ausgeführten Magnet versehen ist, einem Magnetwiderstandselement zur Feststellung der Umdrehungen dieser Codescheibe, einer Wellenformkorrekturschaltung, die die Wellenform des Signals vom Magnetwiderstandselement korrigiert, und einem Steuerkreis (Zähler), um die Feststellsignale von mehreren Umdrehungen zu zählen und den Zahlenwert zu speichern.

Der Ringmagnet ist so ausgeführt, dass sich seine Magnetpole während einer Umdrehung umkehren. Durch die Feststellung dieser Umkehr der Magnetpole mittels des Magnetwiderstandselements kann eine Umdrehung festgestellt werden. Der Aufbau zur Feststellung einer Umdrehung und der Aufbau zur Feststellung von mehreren Umdrehungen einer derartigen Positionsmesseinrichtung kann als optisches System oder als Magnetsystem ausgeführt sein. Für den Aufbau der einzelnen Teile, ihre Anordnung usw. gibt es je nach der Art der Positionsmesseinrichtung verschiedenste Ausführungen. Zum Beispiel gibt es wie in der JP7218290A2 gezeigt auch Positionsmesseinrichtungen, bei denen nur eine optische Abtastung verwendet wird und auch das Signal zur Feststellung von mehreren Umdrehungen durch ein optisches System gebildet wird. Außerdem gibt es wie in der JP10325740A2 gezeigt Positionsmesseinrichtungen, bei denen nur eine optische Abtastung verwendet wird und das werthöchste Bit des Absolutsignals als Signal zur Feststellung von mehreren Umdrehungen verwendet wird. Im Allgemeinen wird durch die Ausführung der Multiturnstufe als magnetisches System ein geringer Energieverbrauch möglich, was für eine lange Lebensdauer einer Pufferstromquelle von Vorteil ist.

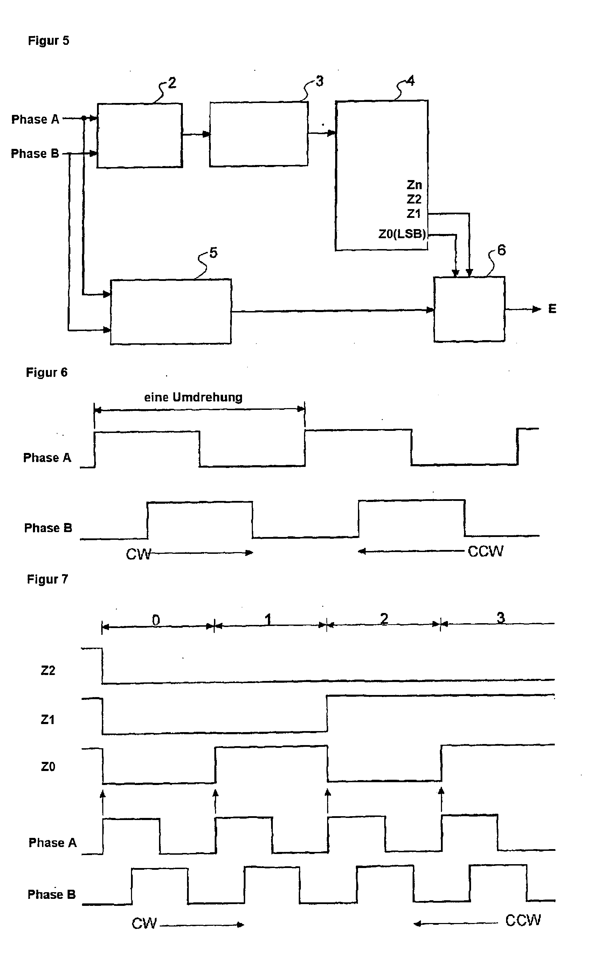

Unabhängig davon, welches System verwendet wird, besteht das Basissignal zur Feststellung von mehreren Umdrehungen im Allgemeinen aus wie in Figur 6 gezeigten Signalen der Phase A und der Phase B, deren Phase sich um 90° unterscheidet, und die bei einer Umdrehung eine Periode bilden. Durch die Verwendung derartiger zwei Signale mit Phasenunterschied wird eine Feststellung der Umdrehungsrichtung möglich und kann die der Umdrehungsrichtung entsprechende Umdrehungszahl berechnet werden. Figur 6 ist ein Zeitdiagramm, das den Zustand der einzelnen Basissignale zur Feststellung von mehreren Umdrehungen zeigt.

Wenn derartige Basissignale verwendet werden und die Anzahl der Umdrehungen berechnet wird, genügt eine Zählung pro Umdrehung, weshalb die Umdrehungszahl gewöhnlich unter Verwendung einer Schaltflanke der Phase A oder der Phase B gezählt wird. Figur 7 ist ein Zeitdiagramm, das den Vorgang einer solchen Berechnung von mehreren Umdrehungen durch die Signale der Phase A und der Phase B und die Ausgänge der drei von einem Zähler ausgegebenen wertniedrigsten Bits Z0 bis Z2 zeigt. In diesem Beispiel erfolgt die Zählung durch Feststellung der ansteigenden Flanke des Signals der Phase A. Wenn die Umdrehung im Uhrzeigersinn (clockwise; CW) erfolgt, werden die Zählausgänge Z0 bis Z2 des Zählers bei jeder ansteigenden Flanke des Signals der Phase A erhöht und die Umdrehungszahl als 0, 1, 2, 3, ... berechnet.

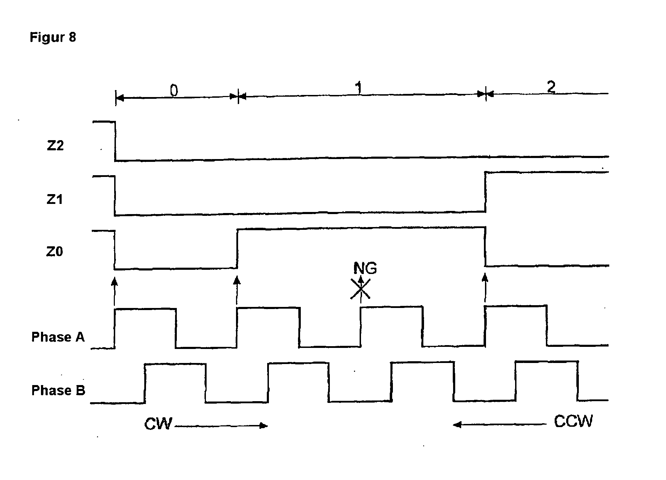

Doch wenn es etwa zu Störungen durch Rauschen oder Störeinstrahlungen kommt und die ansteigende Flanke der Phase A nicht festgestellt werden kann, kommt es zu einem in Figur 8 gezeigten Zählfehler. Dieser Zählfehler kann aus den Signalen der Phase A und der Phase B oder aus dem Zustand der Zählausgänge Z0 bis Z2 nicht erkannt werden, so dass die Fehlzählung übersehen werden kann. Figur 8 ist ein Zeitdiagramm, das das Auftreten einer Fehlzählung NG aufgrund einer nicht festgestellten Flanke der Phase A in Figur 7 zeigt.

Dies liegt daran, dass der entsprechende Zustand des Zählausgangs Z0 bei einer Veränderung des Pegels der Signale der Phase A und der Phase B wie in Tabelle 1 gezeigt sowohl 0 als auch 1 sein kann, und der Zählfehler aus ihrer Beziehung nicht festgestellt werden kann.

**Tabelle 1**

| Phase A | Phase B | Z0 |
|---|---|---|
| 0 | 0 | 0/1 |
| 1 | 0 | 0/1 |
| 0 | 1 | 0/1 |
| 1 | 1 | 0/1 |

Wenn in der Multiturnstufe des Multiturn-Drehgebers ein Zählfehler auftritt, kommt es zu einem Fehler von einer Umdrehung. Daher besteht die Gefahr, dass ein äußerst großer Zahlenfehler für die Positionssteuerungsdaten und daher ein fatales Problem auftritt.

Auch bei der Feststellung des Ausmaßes der Positionsverschiebung innerhalb einer Umdrehung eines inkrementalen oder eines absoluten Drehgebers erfolgt die Zählung unter Verwendung der Signale der Phase A und der Phase B, und auch in diesem Fall besteht die Gefahr, dass derartige Zählfehler auftreten. Um die Verlässlichkeit der Positionsmesseinrichtung zu erhöhen, müssen daher derartige Zählfehler verhindert werden.

Die Aufgabe der vorliegenden Erfindung ist, eine Schaltungsanordnung sowie ein Verfahren zur Feststellung von Zählfehlern einer Positionsmesseinrichtung bereitzustellen.

Diese Aufgabe wird gelöst durch eine Schaltungsanordnung nach Anspruch 1, bzw. durch ein Verfahren nach Anspruch 7.

Es wird nun eine Schaltungsanordnung zur Feststellung von Zählfehlern in einer Positionsmesseinrichtung, die eine dem Positionsverschiebungsausmaß eines zu messenden Objekts entsprechende Impulsreihe feststellt, vorgeschlagen, bei der ein Zähler Zählsignale, die aus wenigstens einem verdoppelten, verdreifachten oder vervierfachten Basissignal zur Berechnung des Positionsverschiebungsausmaßes erzeugt sind, zählt und ein Vergleicher wenigstens ein Ausgangssignal des Zählers mit einem aus dem wenigstens einem Basissignal abgeleiteten Vergleichssignal vergleicht und bei Bestehen einer bestimmten Beziehung ein Zählfehlerausgangssignal ausgibt.

Ebenso wird ein Verfahren zur Feststellung von Zählfehlern einer Positionsmesseinrichtung, die eine dem Positionsverschiebungsausmaß eines zu messenden Objekts entsprechende Impulsreihe feststellt, vorgeschlagen, bei dem Zählsignale, die aus wenigstens einem verdoppelten, verdreifachten oder vervierfachten Basissignal zur Berechnung des Positionsverschiebungsausmaßes erzeugt werden, mit einem Zähler gezählt werden und wenigstens ein Ausgangssignal des Zählers mit einem aus dem wenigstens einem Basissignal abgeleiteten Vergleichssignal mittels eines Vergleichers verglichen wird und bei Bestehen einer bestimmten Beziehung ein Zählfehlerausgangssignal ausgegeben wird.

Durch die vorliegende Erfindung können eine Schaltungsanordnung und ein Verfahren zur Feststellung von Zählfehlern einer Positionsmesseinrichtung bereitgestellt werden, wodurch die Feststellung von Zählfehlern zur Zeit der Messung durch eine einfache Gestaltung möglich wird. Die erfindungsgemäße Schaltungsanordnung kann darüber hinaus durch geringfügige schaltungstechnische Veränderungen an den herkömmlichen Schaltkreisen einer Positionsmesseinrichtung mit äußerst hoher Verlässlichkeit verwirklicht werden.

Durch die Verdopplung, Verdreifachung oder Vervierfachung der Basissignale zur Berechnung des Positionsverschiebungsausmaßes und ihre Verwendung als Zählsignale kommt es dazu, dass die Pegel wenigstens eines der Ausgangssignale des Zählers, insbesondere eines der zwei wertniedrigsten Bits, eine bestimmte logische Beziehung zu den Basissignalen aufweisen. Daher kann durch einen Vergleich das Auftreten eines Zählfehlers festgestellt und ein Zählfehlerausgangssignal erzeugt werden.

Vorteilhafte Ausführungen ergeben sich aus den von den Ansprüchen 1 und 7 abhängigen Ansprüchen.

Weitere Vorteile und Einzelheiten der vorliegenden Erfindung ergeben sich aus der nachfolgenden Beschreibung der Figuren. Dabei zeigt
- Figur 1: ein Zeitdiagramm, das die Funktionsweise einer ersten Ausführungsform zeigt, wobei der Vorgang der Berechnung des Positionsverschiebungsausmaßes durch die Signale der Phase A und der Phase B und die Ausgänge der drei vom Zähler ausgegebenen wertniedrigsten Bits gezeigt ist,
- Figur 2: ein Zeitdiagramm, das das Auftreten einer Fehlzählung NG aufgrund einer nicht festgestellten Flanke der Phase A in Figur 1 zeigt,
- Figur 3: ein Zeitdiagramm, das die Funktionsweise einer zweiten Ausführungsform zeigt, wobei der Vorgang der Berechnung des Positionsverschiebungsausmaßes durch die Signale der Phase A und der Phase B und die Ausgänge der drei vom Zähler ausgegebenen wertniedrigsten Bits gezeigt ist,
- Figur 4: ein Zeitdiagramm, das das Auftreten einer Fehlzählung NG aufgrund einer nicht festgestellten Flanke der Phase A in Figur 3 zeigt,
- Figur 5: ein Blockdiagramm, das den grundlegenden Aufbau einer erfindungsgemäßen Schaltungsanordnung zeigt,
- Figur 6: ein Zeitdiagramm, das den Zustand der Basissignale zur Feststellung von mehreren Umdrehungen einer herkömmlichen Positionsmesseinrichtung zeigt,
- Figur 7: ein Zeitdiagramm, das den Vorgang der Berechnung von mehreren Umdrehungen der Positionsmesseinrichtung von Figur 6 durch die Signale der Phase A und der Phase B und die Ausgänge der drei vom Zähler ausgegebenen wertniedrigsten Bits zeigt,
- Figur 8: ein Zeitdiagramm, das das Auftreten einer Fehlzählung NG aufgrund einer nicht festgestellten Flanke der Phase A in Figur 7 zeigt.

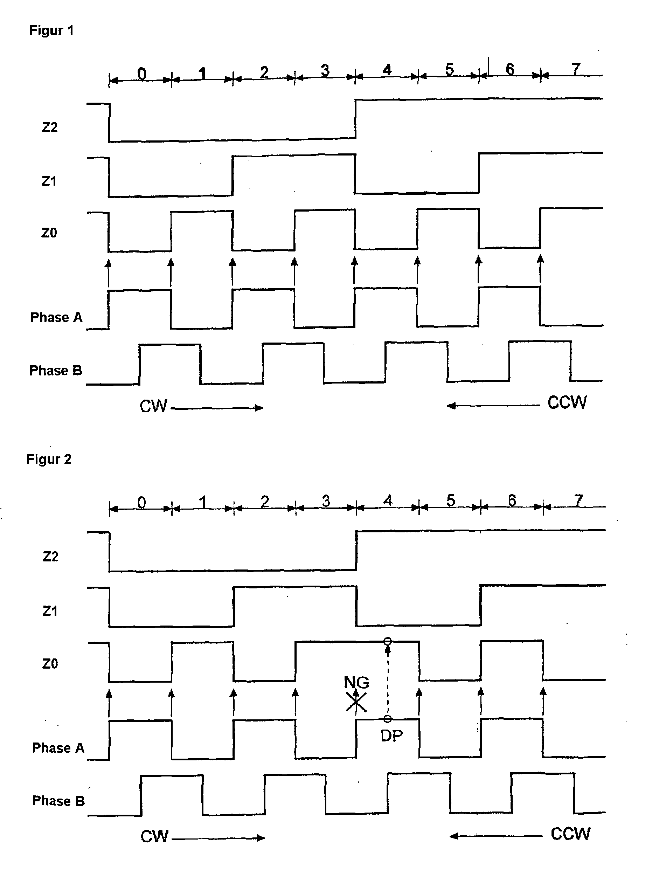

Figur 1 ist ein Zeitdiagramm, das die Funktionsweise einer ersten Ausführungsform der vorliegenden Erfindung zeigt, wobei der Vorgang der Berechnung des Positionsverschiebungsausmaßes, das heißt, des Umdrehungswinkels, der Umdrehungszahl, des Bewegungsausmaßes o.ä., durch die Signale der Phase A und der Phase B und die Ausgänge der drei von einem Zähler ausgegebenen wertniedrigsten Bits Z0 bis Z2 gezeigt ist. In diesem Beispiel wird bei der Umdrehungsfeststellung des Drehgebers die ansteigende Flanke und die abfallende Flanke des Signals der Phase A festgestellt und als Zählsignal eingesetzt. Auch bei einem linearen Positionsmessgerät ist dieses Prinzip anwendbar, wenn die Umdrehungsrichtung als Bewegungsrichtung angesehen wird.

Wenn in der Figur das nicht dargestellte Zählsignal durch Feststellen der ansteigenden Flanke und der abfallenden Flanke eines der Basissignale der Phase A und der Phase B, zum Beispiel der Phase A, gebildet wird, entsteht ein gegenüber dem Signal der Phase A verdoppeltes Zählsignal, d.h. je Periode des Signals der Phase A wird zweimal gezählt. Wenn die Umdrehung im Uhrzeigersinn (CW) erfolgt, werden die Zählausgange Z0 bis Z2 des Zählers mit jeder ansteigenden und abfallenden Flanke des Signals der Phase A erhöht, und die Umdrehungszahl als 0, 1, 2, 3, ... berechnet. Da das Ausgangssignal Z0 der wertniedrigsten Bits (LSB) des Zählers, der diese Zählung vornimmt, mit dem verdoppelten Zählsignal übereinstimmt, ergibt sich ein Signal mit der umgekehrten Phase des Signals der Phase A. Das heißt, der Pegel des Ausgangssignals Z0 des wertniedrigsten Bits (LSB) stimmt wie in der nachstehenden Tabelle 2 gezeigt mit der umgekehrten Phase des Signals der Phase A, das heißt, mit dem Pegel der logischen Negation, überein.

**Tabelle 2**

| Phase A | Phase B | Z0 |
|---|---|---|
| 0 | 0 | 1 |
| 1 | 0 | 0 |
| 0 | 1 | 1 |
| 1 | 1 | 0 |

Wenn wie in Figur 2 gezeigt ein Feststellfehler NG der ansteigenden Flanke der Phase A auftritt, verändert sich der Pegel des Ausgangssignals Z0 des wertniedrigsten Bits (LSB) nicht und entspricht somit mit dem Pegel des Signals der Phase A. Wenn eine geeignete Stelle, an der die Signalpegel stabil sind, als Feststellpunkt DP angenommen wird und die Pegel der beiden Signale mit geeigneten Mitteln verglichen werden, kann daher durch eine Feststellung der Übereinstimmung dieser Pegel ein Zählfehler erkannt werden. Noch konkreter kann durch den Erhalt der logischen Summe (UND-Verknüpfung) der beiden Signalpegel oder durch den Erhalt der exklusiven logischen Summe (exklusive UND-Verknüpfung) leicht eine Beurteilung erfolgen.

Beim obigen Beispiel wurden die ansteigende und die abfallende Flanke des Signals der Phase A festgestellt und ein verdoppeltes Zählsignal erzeugt. Ebenso kann hierfür das Signal der Phase B herangezogen werden. Außerdem können auch entweder die ansteigenden Flanken der Phasen A und B oder die abfallenden Flanken der Phasen A und B verwendet und zum verdoppelten Zählsignal gemacht werden. Das heißt, wenn eines der Basissignale verdoppelt wird und zum Beispiel auf die Multiturn-Stufe eines Drehgebers angewendet wird, ist durch die Bildung eines Zählsignals, das pro Umdrehung zwei Zählungen vornimmt, eine Verarbeitung durch die gleichen Mittel möglich. Das gleiche gilt auch für die Berechnung eines Inkrementalsignals.

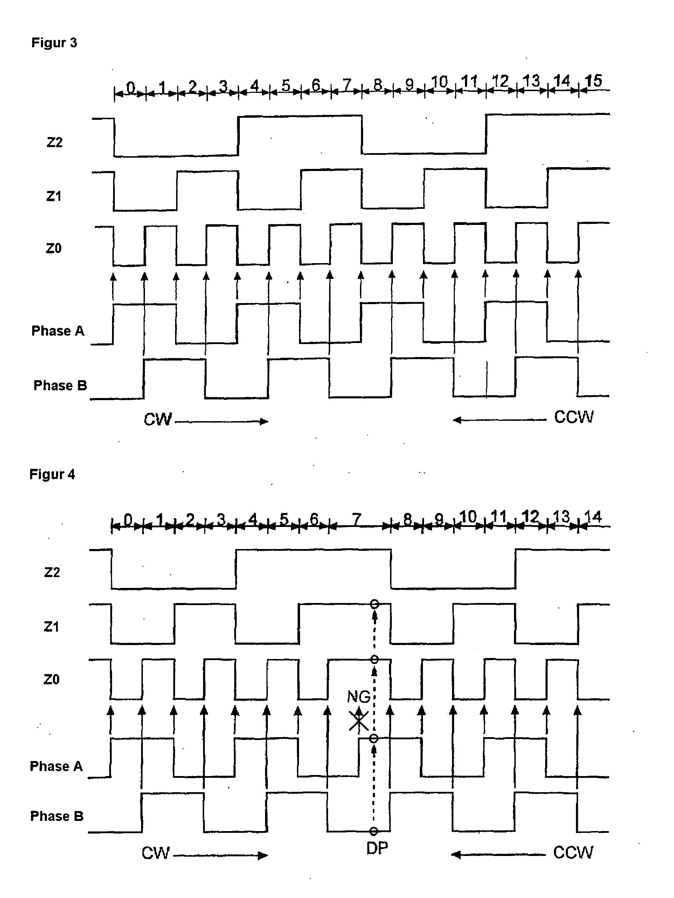

Figur 3 ist ein Zeitdiagramm, das den Betrieb einer zweiten Ausführungsform der vorliegenden Erfindung zeigt. In diesem Beispiel wird die ansteigende und die abfallende Flanke des Signals der Phase A und die ansteigende und die abfallende Flanke des Signals der Phase B festgestellt und gezählt.

Wenn ein in der Figur 3 nicht dargestellter Zähler von den Basissignalen der Phase A und der Phase B die ansteigende Flanke und die abfallende Flanke des Signals der Phase A und die ansteigende Flanke und die abfallende Flanke des Signals der Phase B feststellt und als Zählsignal verwendet, entspricht das Zählsignal dem vierfachen Signal des Signals der Phase A oder des Signals der Phase B, d.h. je Periode der Basissignale wird viermal gezählt. Wenn die Umdrehung im Uhrzeigersinn (CW) erfolgt, werden die Zählausgänge Z0 bis Z2 des Zählers mit jeder ansteigenden und abfallenden Flanke des Signals der Phase A und ansteigenden und abfallenden Flanke des Signals der Phase B erhöht, und wird das Positionsverschiebungsausmaß als 0, 1, 2, 3, ... berechnet. Daher stimmt das Ausgangssignal Z0 des wertniedrigsten Bits (LSB) des Zählers, der diese Zählung vornimmt, mit dem vervierfachten Zählsignal überein.

Der Pegel des Ausgangssignals Z1 des zweitniedrigsten Bits des Zählers entspricht in diesem Beispiel der logischen Negation des Signals der Phase A. Weiter stimmt der Pegel des Ausgangssignals Z0 des wertniedrigsten Bits (LSB) des Zählers, wie in der nachstehenden Tabelle 3 gezeigt, mit der exklusiven logischen Summe der Signalpegel der Phase A und der Phase B überein.

**Tabelle 3**

| Phase A | Phase B | Z0 | Z1 |
|---|---|---|---|
| 0 | 0 | 1 | 1 |
| 1 | 0 | 0 | 0 |
| 0 | 1 | 0 | 1 |
| 1 | 1 | 1 | 0 |

Allgemein betrachtet kann, abhängig davon, welche Flanke als erste Zählflanke gewählt wird, der Pegel des Ausgangssignals Z0 des wertniedrigsten Bits (LSB) des Zählers mit der exklusiven logischen Summe der Signalpegel der Phase A und der Phase B oder mit ihrer Negation übereinstimmen. Ebenso kann der Pegel des Ausgangssignals Z1 sowohl direkt mit dem Pegel des Signals der Phase A oder dem Pegel des Signals der Phase B übereinstimmen oder mit dem Pegel der umgekehrten Phase des Signals der Phase A oder der Phase B, das heißt, der logischen Negation.

Wenn, wie in Figur 4 gezeigt, ein Feststellfehler NG aufgrund einer nicht festgestellten Flanke der Phase A auftritt, verändert sich der Pegel des Ausgangssignals Z0 des wertniedrigsten Bits (LSB) beim Auftreten eines Zählfehlers nicht. Daher stimmt der Pegel des Signals der Phase A mit dem Pegel des Ausgangssignals Z1 des zweitniedrigsten Bits überein. Außerdem stimmt der Pegel des Ausgangssignals Z0 des wertniedrigsten Bits (LSB) nicht mehr mit der exklusiven logischen Summe der Pegel des Signals der Phase A und des Signals der Phase B überein.

Wenn eine passende Stelle, an der die Signalpegel stabil sind, als Feststellpunkt DP angenommen wird und die Pegel des Signals der Phase A und des Signals der Phase B und die Pegel des Ausgangssignals Z0 des wertniedrigsten Bits (LSB) und des Ausgangssignals Z1 des zweitniedrigsten Bits mit geeigneten Mitteln verglichen werden, kann daher durch eine Bestätigung der Übereinstimmung des Pegels des Ausgangssignals Z1 des zweitniedrigsten Bits und des Pegels der Phase A oder der fehlenden Übereinstimmung des Pegels des Ausgangssignals Z0 des wertniedrigsten Bits (LSB) mit der exklusiven logischen Summe der Pegel des Signals der Phase A und des Signals der Phase B ein Zählfehler festgestellt werden. Diese Feststellmittel können einen Zählfehler aus dem Pegel des Ausgangssignals Z1 des zweitniedrigsten Bits und/oder dem Pegel des Ausgangssignals Z0 des wertniedrigsten Bits (LSB) feststellen. Durch die Verwendung beider Pegel wird eine doppelte Feststellung möglich, was die Sicherheit der Vorrichtung besonders verbessert.

Beim obigen Beispiel wurde die ansteigende und die abfallende Flanke der Signale der Phase A und der Phase B festgestellt und zu einem vervierfachten Zählsignal gemacht. Es ist jedoch auch möglich, nur drei Flanken des Signals der Phase A und des Signals der Phase B zu verwenden und ein verdreifachtes Zählsignal zu erzeugen.

Unabhängig davon, ob die Basissignale verdrei- oder vervierfacht werden, ist eine Verarbeitung durch vergleichbare Mittel möglich. Das gilt sowohl für die Anwendung auf die Multiturnstufe eines Drehgebers, als auch für die Auswertung von Inkrementalsignalen zur Feststellung des Positionsverschiebungsausmaßes, d.h. des Umdrehungswinkels oder des Bewegungsausmaßes eines Drehgebers oder eines linearen Positionsmessgeräts. Eine Anwendung auf die wertniedrigsten Bits eines Absolutsignals oder auf die werthöchsten Bits zur Feststellung der Anzahl der Umdrehungen ist ebenfalls möglich.

Anschließend wird der konkrete Aufbau der Vorrichtung der vorliegenden Erfindung erklärt. Figur 5 ist ein Blockdiagramm, das den grundlegenden Aufbau einer erfindungsgemäßen Schaltungsanordnung zur Feststellung von Zählfehlern in einer Positionsmesseinrichtung zeigt. In der Figur weist die Schaltungsanordnung eine Vervielfachungseinheit 2, eine Zählsignalumwandlungseinheit 3, einen Zähler 4, eine Vergleichssignalbearbeitungs- und -auswahleinheit 5, und einen Vergleicher 6 auf.

Die Vervielfachungseinheit 2 verdoppelt, verdreifacht oder vervierfacht die von einem nicht dargestellten Positionsverschiebungsausmaß-Feststellteil ausgegebenen Basissignale der Phase A und der Phase B. Die Zählsignalumwandlungseinheit 3 dient dazu, aus den vervielfachten Signalen der Phase A und der Phase B Zählsignale zur Addition (aufwärts) oder Subtraktion (abwärts) zu bilden, die der Zähler 4 zählt und einen dem Zählwert entsprechenden Zählausgang bildet. Die Vergleichssignalbearbeitungs- und - auswahleinheit 5 erzeugt aus den Signalen der Phase A und der Phase B ein Vergleichssignal zum Vergleich mit dem Zählausgang. Der Vergleicher 6 vergleicht schließlich das Zählausgangssignal vom Zähler und das Vergleichssignal und gibt als Ergebnis ein Zählfehlersignal E aus.

Die Vervielfachungseinheit 2 stellt, wie oben erwähnt, die ansteigende und/oder abfallende Flanke der Phase A und/oder der Phase B fest und bildet aus diesen Basissignalen ein vervielfachtes Signal. Die Vervielfachungseinheit 2 kann durch die Verwendung bekannter digitaler Bauelemente wie zum Beispiel einer Flipflop-Schaltung, die durch ansteigende und/oder abfallende Flanken betrieben wird, leicht aufgebaut werden.

Die Zählsignalumwandlungseinheit 3 beurteilt aus der Phasenbeziehung der Phase A und der Phase B die Umdrehungsrichtung bzw. die Bewegungsrichtung und bildet aus den vervielfachten Basissignalen Zählsignale, die je nach der Umdrehungsrichtung oder der Bewegungsrichtung zur Addition (aufwärts) oder zur Subtraktion (abwärts) bestimmt sind. Zum Beispiel erscheinen beim obigen Beispiel bei Umdrehungen im Uhrzeigersinn (clock-wise; CW) Impulse in der Reihenfolge Phase A, Phase B, wohingegen die Reihenfolge bei Umdrehungen gegen den Uhrzeigersinn (counter-clockwise; CCW) umgekehrt ist. Daher können die Signale bei Erscheinen der Impulse in der Reihenfolge Phase A, Phase B als Additionssignale und im umgekehrten Fall als Subtraktionssignale angesetzt werden. Bei einem linearen Positionsmessgerät kann die Umdrehungsrichtung durch die Bewegungsrichtung ersetzt werden. Auch für die Zählsignalumwandlungseinheit 3 können allgemein bekannte Bauteile eingesetzt werden.

Der Zähler 4 zählt die eingegebenen Zählsignale. Wenn ein Signal zur Addition (aufwärts) eingegeben wird, wird der Zählwert erhöht, und wenn ein Signal zur Subtraktion (abwärts) eingegeben wird, wird der Zählwert verringert. Auch dieser Zähler 4 kann durch eine Kombination von herkömmlich verwendeten Zählerbausteinen und logischen Schaltungen leicht aufgebaut werden. Da das Zählsignal ein Vielfaches der Basissignale ist, ist bei der Kapazität des Zählers 4 der Multiturnstufe (der Ausgangsbitzahl) eine Erhöhung um die Bitzahl der Vervielfachung nötig. Zum Beispiel wird die Zählerkapazität bei einer Verdopplung der Zählsignale und einer Ausgangsbitzahl von 16 Bit auf 17 Bit erhöht, da hierfür ein zusätzliches Bit benötigt wird.

Die Vergleichssignalbearbeitungs- und -auswahleinheit 5 wählt aus den Basissignalen der Phase A und der Phase B Signale, die mit dem Zählausgang des Zählers 4 verglichen werden können, verarbeitet diese Signale etwa durch logische Negation, Bildung der logische Summe oder der exklusiven logischen Summe, und wandelt sie in Vergleichssignale um, die mit dem Zählausgang verglichen werden können. Diese Verarbeitung kann durch eine Kombination von herkömmlichen logischen Bauteilen o.ä. leicht vorgenommen werden.

Der Vergleicher 6 vergleicht das Zählsignal Z0 des wertniedrigsten Bits (LSB) oder das Zählsignal Z1 des zweitniedrigsten Bits des Zählers 4 und das Vergleichssignal von der Vergleichssignalbearbeitungs- und -auswahleinheit 5 und bildet ein Zählfehlerausgangssignal E, wodurch das Vorhandensein bzw. Nichtvorhandensein eines Feststellfehlers beurteilt werden kann. Was die verglichenen Signale betrifft, sollen instabile Zustände, bei denen sich das Signal zur Feststellung des Positionsverschiebungsausmaßes durch ein Ansteigen oder Abfallen verändert und sich der Zähler verändert, vermieden werden und die Pegel von Bereichen, in denen das Signal zur Feststellung des Positionsverschiebungsausmaßes und das Zählausgangssignal stabil sind, verglichen werden. Für den Vergleicher kann ein allgemein bekanntes Vergleichselement wie etwa zum Beispiel ein Komparator verwendet werden. Da es sich jedoch um einen einfachen Vergleich von logischen Pegeln von zwei Signalen handelt, ist auch ein Aufbau möglich, bei dem eine logische Schaltung verwendet wird, die zum Beispiel zur Bildung einer logischen Summe, einer exklusiven logischen Summe o.ä. geeignet ist.

Erfindungsgemäße Schaltungsanordnungen sind zum Beispiel für den Einsatz in einer Multiturnstufe eines Multiturn-Drehgebers zur Feststellung von Zählfehlern bei mehreren Umdrehungen geeignet. Für den Multiturn-Drehgeber ist eine Positionsmesseinrichtung mit einem Aufbau günstig, wie er zum Beispiel in der JP63083612A2 offenbart ist. Dieser Multiturn-Drehgeber ist mit einem optischen absoluten Geber zur Feststellung des absoluten Winkels innerhalb einer Umdrehung und einem magnetischen Geber, der die Anzahl der zurückgelegten Umdrehungen feststellt, versehen. Der optische absolute Geber zur Feststellung des absoluten Winkels innerhalb einer Umdrehung besteht u.a. aus einer an einer Welle angebrachten Codescheibe, einer Leuchtdiode, um die Codescheibe zu bestrahlen, einer Photodiodenanordnung eines Lichtempfangselements, das das Licht der Leuchtdiode über eine Abtastplatte empfängt, und eine Wellenformkorrekturschaltung zur Umwandlung der Wellenform des Feststellsignals von der Photodiodenanordnung zu Rechteckwellen. Der magnetische Geber zur Feststellung von mehreren Umdrehungen besteht u.a. aus einer Codescheibe am Drehteil, die mit einem als Ringmagnet ausgeführten Magnet versehen ist, einem Magnetwiderstandselement zur Feststellung der Umdrehungen dieser Codescheibe, einer Wellenformkorrekturschaltung, die die Wellenform des Signals vom Magnetwiderstandselement korrigiert, und einem Steuerkreis (Zähler), um die Feststellsignale von mehreren Umdrehungen zu zählen und den Zahlenwert zu speichern.

Das Ausgangssignal der Wellenformkorrekturschaltung, die die Wellenform des Signals vom Magnetwiderstandselement korrigiert, entspricht dem Basissignal der Phase A und der Phase B der vorliegenden Erfindung, und der Steuerkreis entspricht dem Zähler.

Die Schaltungsanordnung und das Verfahren zur Feststellung von Zählfehlern einer Positionsmesseinrichtung können nicht nur auf die Multiturn-Stufe eines derartigen Multiturn-Drehgebers, sondern durch gleichartige Verfahren auch auf inkrementale Drehgeber oder lineare Positionsmessgeräte angewendet werden. Da der ausführliche Aufbau derartiger Positionsmesseinrichtungen in verschiedensten Literaturbeispielen offenbart ist, wird hier auf eine Beschreibung verzichtet.

Sofern es sich um eine Positionsmesseinrichtung handelt, bei der das Positionsverschiebungsausmaß durch die Ausgabe einer dem Positionsverschiebungsausmaß entsprechenden Impulsreihe und ihre Auswertung festgestellt werden kann, können die Schaltungsanordnung und das Verfahren zur Feststellung von Zählfehlern der vorliegenden Erfindung unabhängig von der Art der Positionsmesseinrichtung angewendet werden. Zum Beispiel ist eine Anwendung auf verschiedenste Zählfunktionen einer Positionsmesseinrichtung wie etwa die Zählung des Inkrementalsignals, die Zählung des Absolutsignals, und die Zählung der Umdrehungszahl eines Multiturn-Drehgebers, oder die Zählung des Inkrementalsignals eines linearen Positionsmessgeräts möglich.

## Patentansprüche

1. Schaltungsanordnung zur Feststellung von Zählfehlern in einer Positionsmesseinrichtung, die eine dem Positionsverschiebungsausmaß eines zu messenden Objekts entsprechende Impulsreihe feststellt, **dadurch gekennzeichnet, dass**
- ein Zähler (4) Zählsignale, die aus wenigstens einem verdoppelten, verdreifachten oder vervierfachten Basissignal (Phase A, Phase B) zur Berechnung des Positionsverschiebungsausmaßes erzeugt sind, zählt und
- ein Vergleicher (6) wenigstens ein Ausgangssignal (Z0, Z1) des Zählers (4) mit einem aus dem wenigstens einem Basissignal (Phase A, Phase B) abgeleiteten Vergleichssignal vergleicht und bei Bestehen einer bestimmten Beziehung ein Zählfehlerausgangssignal (E) ausgibt.

2. Schaltungsanordnung nach Anspruch 1, **dadurch gekennzeichnet, dass** die Verdopplung, Verdreifachung oder Vervierfachung des wenigstens einen Basissignals (Phase A, Phase B) in einer Vervielfachungseinheit (2) erfolgt.

3. Schaltungsanordnung nach Anspruch 1 oder 2, **dadurch gekennzeichnet, dass** das verdoppelte, verdreifachte oder vervierfachte wenigstens eine Basissignal (Phase A, Phase B) zur Bildung des Zählsignals unter Berücksichtigung der Umdrehungsrichtung bzw. der Bewegungsrichtung einer Zählsignalumwandlungseinheit (3) zugeführt ist.

4. Schaltungsanordnung nach einem der vorhergehenden Ansprüche, **dadurch gekennzeichnet, dass** die Vergleichssignale in einer Vergleichssignalbearbeitungs- und -auswahleinheit (5) aus wenigstens einem der Basissignale (Phase A, Phase B) erzeugbar sind.

5. Schaltungsanordnung nach einem der vorhergehenden Ansprüche, **dadurch gekennzeichnet, dass** für den Vergleich im Vergleicher (6) das wertniedrigste Bit (Z0) des Zählers (4) und/oder das zweitniedrigste Bit (Z1) des Zählers (4) verwendet wird.

6. Schaltungsanordnung nach einem der vorhergehenden Ansprüche, **dadurch gekennzeichnet, dass** Zählfehler der Multiturnstufe eines Multiturn-Drehgebers feststellbar sind.

7. Verfahren zur Feststellung von Zählfehlern einer Positionsmesseinrichtung, die eine dem Positionsverschiebungsausmaß eines zu messenden Objekts entsprechende Impulsreihe feststellt, **dadurch gekennzeichnet, dass**
- Zählsignale, die aus wenigstens einem verdoppelten, verdreifachten oder vervierfachten Basissignal (Phase A, Phase B) zur Berechnung des Positionsverschiebungsausmaßes erzeugt werden, mit einem Zähler (4) gezählt werden und
- wenigstens ein Ausgangssignal (Z0, Z1) des Zählers (4) mit einem aus dem wenigstens einem Basissignal (Phase A, Phase B) abgeleiteten Vergleichssignal mittels eines Vergleichers (6) verglichen wird und bei Bestehen einer bestimmten Beziehung ein Zählfehlerausgangssignal (E) ausgegeben wird.

8. Verfahren nach Anspruch 7, **dadurch gekennzeichnet, dass** durch feststellen der ansteigenden und/oder abfallenden Flanken des wenigstens einen Basissignals (Phase A, Phase B) in einer Vervielfachungseinheit (2) ein vervielfachtes Signal gebildet wird und die Zählsignale in einer Zählsignalumwandlungseinheit (3) aus dem vervielfachten Signal nach der Ermittlung der Umdrehungsrichtung bzw. der Bewegungsrichtung erzeugt werden.

9. Verfahren nach einem der Ansprüche 7 oder 8, **dadurch gekennzeichnet, dass** das Vergleichssignal in einer Vergleichssignalbearbeitungs- und -auswahleinheit (5) durch Verarbeitung des wenigstens einen Basissignals (Phase A, Phase B) gebildet wird.

10. Verfahren nach einem der Ansprüche 7 bis 9, **dadurch gekennzeichnet, dass** der Vergleicher (6) das Vergleichssignal mit einem Zählsignal (Z0) des wertniedrigsten Bits des Zählers (4) und/oder einem Zählsignal (Z1) des zweitniedrigsten Bits des Zählers (4) vergleicht.

## Claims

1. Circuit arrangement for determining counting errors in a position measuring device which determines a pulse sequence corresponding to the extent of the shift in the position of an object to be measured, **characterized in that**
- a counter (4) counts counting signals which are generated from at least one doubled, tripled or quadrupled base signal (phase A, phase B) for the purpose of calculating the extent of the shift in the position, and
- a comparator (6) compares at least one output signal (Z0, Z1) from the counter (4) with a comparison signal derived from the at least one base signal (phase A, phase B) and outputs a counting error output signal (E) if a particular relationship exists.

2. Circuit arrangement according to Claim 1, **characterized in that** the at least one base signal (phase A, phase B) is doubled, tripled or quadrupled in a multiplication unit (2).

3. Circuit arrangement according to Claim 1 or 2, **characterized in that** the doubled, tripled or quadrupled at least one base signal (phase A, phase B) is supplied to a counting signal conversion unit (3) for the purpose of forming the counting signal taking into account the direction of rotation or the direction of movement.

4. Circuit arrangement according to one of the preceding claims, **characterized in that** the comparison signals can be generated from at least one of the base signals (phase A, phase B) in a comparison signal processing and selection unit (5).

5. Circuit arrangement according to one of the preceding claims, **characterized in that** the least significant bit (Z0) of the counter (4) and/or the second lowest bit (Z1) of the counter (4) is/are used for the comparison in the comparator (6).

6. Circuit arrangement according to one of the preceding claims, **characterized in that** counting errors of the multi-turn stage of a multi-turn encoder can be determined.

7. Method for determining counting errors of a position measuring device which determines a pulse sequence corresponding to the extent of the shift in the position of an object to be measured, **characterized in that**
- counting signals which are generated from at least one doubled, tripled or quadrupled base signal (phase A, phase B) for the purpose of calculating the extent of the shift in the position are counted using a counter (4), and
- at least one output signal (Z0, Z1) from the counter (4) is compared with a comparison signal derived from the at least one base signal (phase A, phase B) using a comparator (6) and a counting error output signal (E) is output if a particular relationship exists.

8. Method according to Claim 7, **characterized in that** a multiplied signal is formed by determining the rising and/or falling edges of the at least one base signal (phase A, phase B) in a multiplication unit (2) and the counting signals are generated from the multiplied signal in a counting signal conversion unit (3) after the direction of rotation or the direction of movement has been determined.

9. Method according to either of Claims 7 and 8, **characterized in that** the comparison signal is formed in a comparison signal processing and selection unit (5) by processing the at least one base signal (phase A, phase B).

10. Method according to one of Claims 7 to 9, **characterized in that** the comparator (6) compares the comparison signal with a counting signal (Z0) of the least significant bit of the counter (4) and/or a counting signal (Z1) of the second lowest bit of the counter (4).

## Revendications

1. Circuit permettant de détecter des erreurs de comptage d'un dispositif de mesure de position qui détecte une série d'impulsions qui correspondent à l'amplitude du décalage de position d'un objet à mesurer, **caractérisé en ce que**
un compteur (4) compte des signaux de comptage qui sont formés d'au moins un signal de base (phase A, phase B) doublé, triplé ou quadruplé pour le calcul de l'amplitude du décalage de position et
**en ce qu'**un comparateur (6) compare au moins un signal de sortie (Z0, Z1) du compteur (4) à un signal de comparaison dérivé du ou des signaux de base (phase A, phase B) et qui délivre un signal (E) de sortie d'erreur de comptage en cas de présence d'une relation définie.

2. Circuit selon la revendication 1, **caractérisé en ce que** le doublement, le triplement ou le quadruplement du ou des signaux de base (phase A, phase B) s'effectue dans une unité de multiplication (2).

3. Circuit selon les revendications 1 ou 2, **caractérisé en ce que** le ou les signaux de base (phase A, phase B) doublés, triplés ou quadruplés sont amenés à une unité (3) de conversion de signal de comptage en vue de la formation du signal de comptage en tenant compte de la direction de rotation ou de la direction de déplacement.

4. Circuit selon l'une des revendications précédentes, **caractérisé en ce que** les signaux de comparaison peuvent être formés à partir d'au moins un des signaux de base (phase A, phase B) dans une unité (5) de traitement et de sélection de signal de comparaison.

5. Circuit selon l'une des revendications précédentes, **caractérisé en ce que** le bit (Z0) de plus basse valeur du compteur (4) et/ou le deuxième bit le plus bas (Z1) du compteur (4) sont utilisés pour la comparaison dans le comparateur (6).

6. Circuit selon l'une des revendications précédentes, **caractérisé en ce que** les erreurs de comptage d'un étage multi-rotation d'un capteur de rotation multi-rotation peuvent être détectées.

7. Procédé permettant de détecter les erreurs de comptage d'un dispositif de mesure de position qui détecte une série d'impulsions qui correspondent à l'amplitude du décalage de position d'un objet à mesurer, **caractérisé en ce que**
des signaux de comptage formés d'au moins un signal de base (phase A, phase B) doublé, triplé ou quadruplé sont comptés par un compteur (4) pour le calcul de l'amplitude du décalage de position et
**en ce qu'**au moins un signal de sortie (Z0, Z1) du compteur (4) est comparé par un comparateur (6) à un signal de comparaison dérivé du ou des signaux de base (phase A, phase B) et **en ce qu'**un un signal (E) de sortie d'erreur de comptage est délivré en cas de présence d'une relation définie.

8. Procédé selon la revendication 7, **caractérisé en ce qu'**un signal quadruplé est formé dans une unité (2) de multiplication par détection des flancs montants et/ou des flancs descendants du ou des signaux de base (phase A, phase B) et **en ce que** les signaux de comptage sont formés dans une unité (3) de conversion de signal de comptage à partir du signal multiplié, après la détermination du sens de rotation ou de la direction de déplacement.

9. Procédé selon l'une des revendications 7 ou 8, **caractérisé en ce que** le signal de comparaison est formé à partir d'au moins un des signaux de base (phase A, phase B) dans une unité (5) de traitement et de sélection de signal de comparaison.

10. Procédé selon l'une des revendications 7 à 9, **caractérisé en ce que** le comparateur (6) compare le signal de comparaison à un signal de comptage (Z0) du bit de plus basse valeur du compteur (4) et/ou à un signal de comptage (Z1) du deuxième bit le plus bas du compteur (4).
